# FASCICULE DE BREVET EUROPEEN

(11) **EP 2 424 058 B1**
(45) Date de publication et mention de la délivrance du brevet: **05.04.2017**
(21) Numéro de dépôt: 11177087.1
(22) Date de dépôt: 10.08.2011
(51) Int. Cl.: H02G 15/34, H01R 4/68

(54) **Procede de gestion de la contraction thermique d'un cable supraconducteur et agencement pour la mise en oeuvre de ce procede**
Verfahren zum Management der thermischen Kontraktion eines superleitenden Kabels, und Anordnung zum Einsatz dieses Verfahrens
Method for managing the thermal contraction of a superconductor cable and arrangement for implementing said method

(30) Priorité: 31.08.2010 FR 1056878
(43) Date de publication de la demande: 29.02.2012
(73) Titulaire: Nexans, 75008 Paris (FR)
(72) Inventeur: Schmidt, Frank, 30855 Langenhagen (DE); Delplace, Sébastien, 59279 LOON-PLAGE (FR); Lallouet, Nicolas, 62132 FIENNES (FR); Marzahn, Erik, 30853 LANGENHAGEN (DE)
(74) Mandataire: Lenne, Laurence

(56) Documents cités:
- EP-A2- 0 144 146
- WO-A2-2008/113366
- GB-A- 196 511

## Description

L'invention concerne un procédé de gestion de la contraction thermique d'un câble supraconducteur et un agencement pour la mise en oeuvre de ce procédé.

Un câble supraconducteur se compose généralement d'un support métallique tel que du cuivre, sur lequel est enroulé un ruban en matériau supraconducteur, lui-même recouvert d'un isolant tel que du papier, et d'un écran métallique externe constitué de bandes ou de fils, de cuivre par exemple. L'ensemble du support, du ruban et de l'isolant est appelé corps de câble dans ce qui suit.

Un câble supraconducteur à haute température est immergé dans un fluide cryogénique afin de fonctionner correctement. Ce refroidissement à une température de l'ordre de -200°C entraîne une contraction thermique significative du câble qui doit être gérée.

Il est connu, par exemple du document de brevet EP 1 489 692, de gérer cette contraction au moyen d'un conducteur flexible raccordé à l'extrémité du câble ou au moyen de contacts glissants.

Ceci étant, il s'avère que ce type de solution n'est pas exploitable industriellement. En effet, la contraction est de l'ordre de 0,3 % de la longueur du câble et, sur des lignes de longueur égale à plusieurs kilomètres, elle atteint plusieurs mètres, ingérables ou difficilement gérables économiquement par des contacts glissants ou des conducteurs flexibles. Il serait nécessaire de plus de réaliser des ouvrages de génie civil additionnels correspondant encombrants, ce qui peut même être impossible compte-tenu de la place disponible.

Par ailleurs, le document de brevet WO 2008/113366 décrit un câble supraconducteur comportant un écran externe et installé entre ses extrémités dans une enceinte ou cryostat remplie d'un fluide cryogénique, ce câble étant pourvu de dispositifs de blocage pour sa stabilité mécanique.

L'invention résout ce problème et propose un procédé de gestion de la contraction thermique d'un câble supraconducteur comportant un corps de câble entouré d'un écran externe constitué de fils ou des bandes résistantes mécaniquement métalliques enroulés selon un certain pas et installé entre ses extrémités dans une enceinte ou cryostat remplie d'un fluide cryogénique, caractérisé en ce qu'il consiste à appliquer mécaniquement un effort de blocage radial uniquement dudit écran en un endroit dit de blocage à proximité desdites extrémités du câble, ledit effort de blocage radial ne sollicitant pas ledit corps de câble, le pas desdits fils ou desdites bandes restant constant en dépit d'une force de contraction résultante constante tendant à resserrer ces fils ou bandes enroulés et à diminuer leur pas d'enroulement entre les deux extrémités du câble, une pression radiale sur tous les autres éléments ou couches du câble supraconducteur constituant le corps de câble les bloquant quant à eux et évitant tout déplacement longitudinal dû à la contraction thermique du câble.

Les éléments conducteurs enroulés selon un certain pas, formant l'écran, sont des fils ou des bandes résistantes mécaniquement qui peuvent donc être serrées sans problème. Il s'agit soit d'éléments résistifs par exemple en cuivre, soit d'éléments métalliques de renforcement mécanique.

Lors du refroidissement d'un tel câble, la force de contraction résultante constante, et de l'ordre de plusieurs tonnes, tend à resserrer ces éléments enroulés de l'écran et à diminuer leur pas d'enroulement, entre les deux extrémités du câble. Selon l'invention, l'écran étant bloqué aux deux endroits de blocage, ce pas reste constant mais il en résulte une pression radiale sur tous les autres éléments ou couches du câble supraconducteur constituant le corps de câble, qui les bloque quant à eux. Seul un blocage de l'écran est donc nécessaire, afin d'éviter tout déplacement longitudinal dû à la contraction thermique du câble.

Selon un mode de réalisation préféré, le procédé consiste à bloquer mécaniquement ledit écran entre chacune desdites extrémités du câble et ladite enceinte.

Avantageusement, le procédé consiste à bloquer mécaniquement ledit écran dans un module de cryostat supplémentaire intercalé entre chacune desdites extrémités du câble et ladite enceinte.

De préférence, ledit effort de blocage est transmis à un dispositif de support fixé au sol ou équivalent.

La contraction entre ledit endroit de blocage et l'extrémité proche du câble peut être gérée par un contact glissant.

Un tel agencement de blocage peut tenir une force relativement élevée de l'ordre de plusieurs tonnes.

L'invention concerne enfin un tel procédé de gestion de la contraction thermique d'un câble supraconducteur, au moyen d'un agencement de blocage comportant une bague disposée sous ledit écran audit endroit de blocage et deux brides annulaires de forme interne complémentaire disposées de part et d'autre du plan de symétrie de ladite bague et serrées l'une à l'autre, au moins l'une desdites brides étant solidarisée à un dispositif de support fixé au sol ou équivalent,
procédé consistant à glisser ladite bague sous ledit écran de l'extrémité du câble jusqu'à l'endroit de blocage puis à mettre en place lesdites brides, ladite bague étant équipée de deux poignées externes amovibles disposées entre deux éléments conducteurs adjacents de l'écran et étant tournée et coulissée jusqu'à l'endroit de blocage.

Un tel procédé n'affecte pas la continuité de l'écran du câble et ne nécessite donc pas de connexion spécifique de l'écran.

Il est par ailleurs particulièrement simple et peu coûteux.

L'invention est décrite ci-après plus en détail en référence aux figures qui ne représentent qu'un mode de réalisation préféré de l'invention.
Les figures 1 et 2 sont des vues en coupe verticale d'une ligne d'un câble supraconducteur conforme à l'invention.
Les figures 3 à 5 sont des vues en coupe verticale d'un agencement de blocage conforme à l'invention.
Les figures 6 à 13 illustrent en perspective le procédé de mise en place de cet agencement, conforme à l'invention.

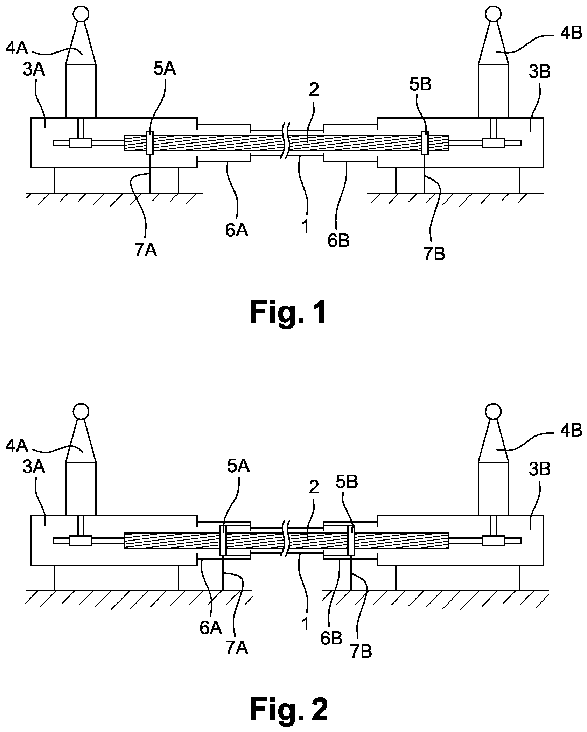

Comme représenté sur les figures 1 et 2, une ligne d'un câble supraconducteur comporte une enceinte remplie d'un fluide cryogénique appelée cryostat 1 contenant le câble 2 dont les extrémités sont disposées dans une terminaison 3A, 3B où le support métallique résistif du câble est raccordé à des sorties 4A, 4B.

Le câble 2 comporte un écran externe constitué d'éléments métalliques, sous forme de fils ou de bandes, enroulés auquel est appliqué mécaniquement un effort de blocage sollicitant uniquement l'écran en un endroit dit de blocage 5A, 5B à proximité des extrémités du câble. Cet effort de blocage ne sollicite pas le corps de câble à l'endroit de blocage.

La ligne peut également comprendre un module de cryostat additionnel 6A, 6B disposé entre le cryostat 1 et les terminaisons 3A, 3B.

De façon générale, le procédé conforme à l'invention consiste à bloquer mécaniquement l'écran entre chacune des extrémités du câble 1 et le cryostat 1.

Ces endroits de blocage peuvent être disposés dans les terminaisons 3A, 3B comme illustré sur la figure 1 ou de préférence dans les modules de cryostat additionnel 6A, 6B comme illustré sur la figure 2.

L'effort de blocage est transmis à un dispositif de support 7A, 7B résistant mécaniquement et fixé au sol ou équivalent. En général, l'agencement de blocage est solidarisé à l'enceinte du cryostat 1 ou du module de cryostat additionnel 6A, 6B et cette enceinte est quant à elle solidement solidarisée au sol.

La contraction entre l'endroit de blocage 5A, 5B et l'extrémité proche du câble peut quant à elle être gérée par un contact glissant.

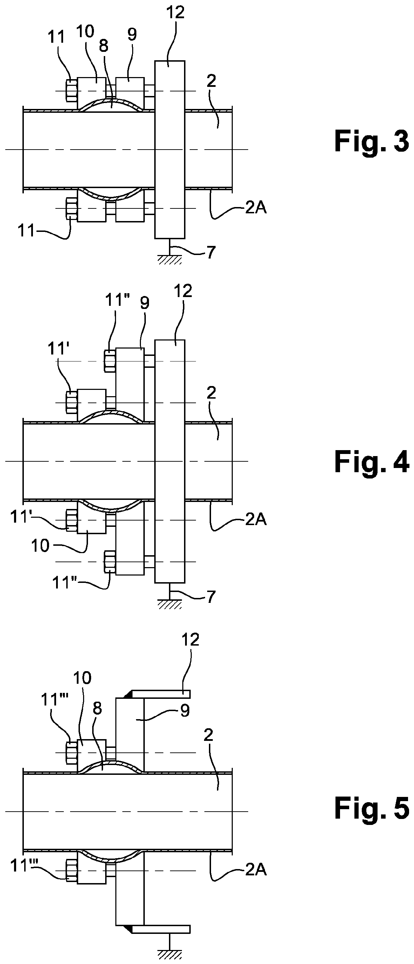

Les figures 3 à 5 représentent en coupe verticale des modes de réalisation d'un agencement de blocage pour la mise en oeuvre d'un tel procédé.

Cet agencement de blocage comporte une bague 8 de surface externe lisse disposée sous l'écran 2A audit endroit de blocage et deux brides annulaires 9, 10 de diamètre interne légèrement supérieur au diamètre externe du câble 1 et de forme interne complémentaire disposées de part et d'autre du plan de symétrie de la bague et serrées l'une à l'autre, au moyen d'un ensemble de vissage. Cette bague présente un diamètre interne légèrement supérieur au diamètre externe du câble hors l'écran 2A.

De préférence, la bague 8 a une surface externe bombée en forme d'arc de cercle et les brides annulaires 9, 10 ont une forme interne arrondie complémentaire.

Cette bague 8 est en matériau résistant mécaniquement et n'a pas de propriété électrique spécifique. Elle est de préférence en acier inoxydable.

Ces brides 9, 10 sont solidarisées à un dispositif de support 12 solidarisé au sol 7.

L'ensemble de vissage 11 peut être unique et assurer la fixation des deux brides 9, 10 ensemble et également sur le dispositif de support 12, comme illustré sur la figure 3.

Deux ensembles de vissage peuvent également être prévus, l'une 11' assurant la fixation des deux brides 9, 10 ensemble, et l'autre 11" assurant la fixation d'une des brides 9 sur le dispositif de support 12, comme illustré sur la figure 4.

L'ensemble de vissage 11"' peut être unique et assurer la fixation des deux brides 9, 10 ensemble, l'une des brides 9 étant soudée sur le dispositif de support 12, comme illustré sur la figure 5.

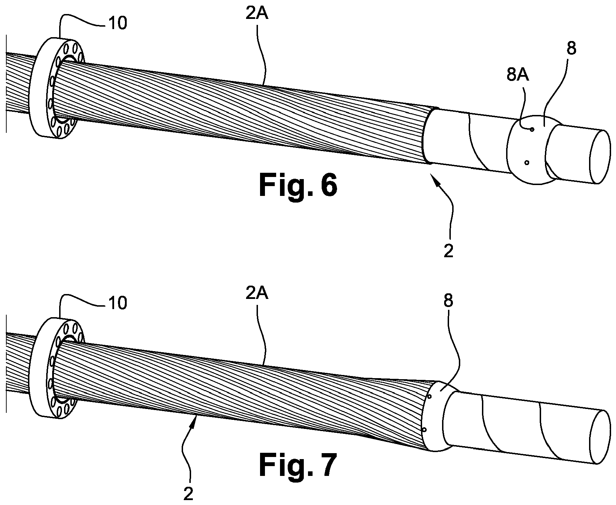

Les figures 6 à 13 illustrent en perspective le procédé de mise en place de cet agencement.

Comme illustré sur la figure 6, une des brides 10 est enfilé sur le câble 2 à son extrémité concernée et une partie de l'écran 2A est enlevée à cette extrémité et la bague 8 y est enfilée. Elle comporte un ensemble d'orifices 8A dont la fonction sera précisée plus loin.

Comme illustré sur la figure 7, la bague 8 est glissée partiellement sous l'écran 2A.

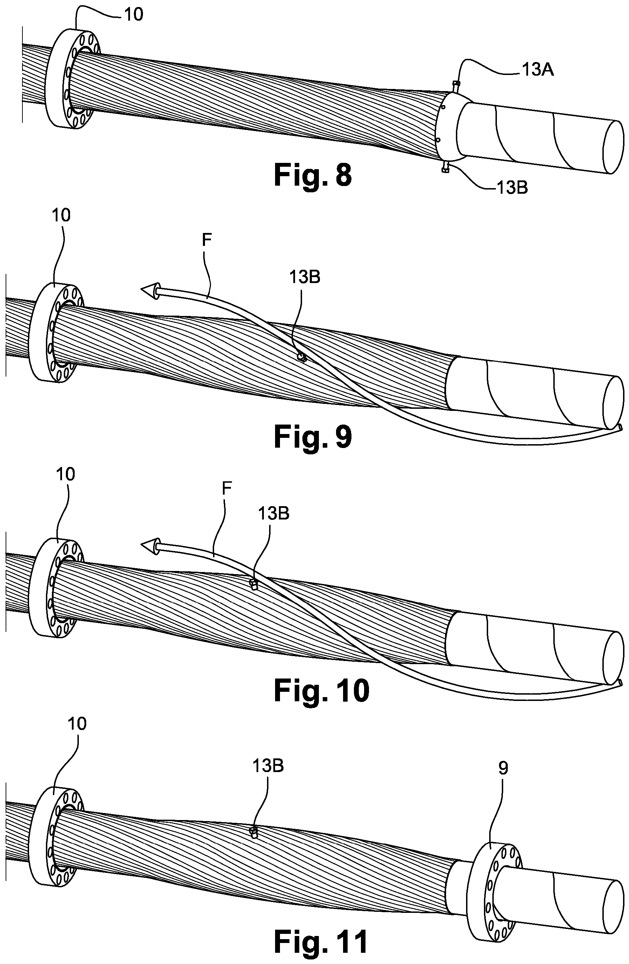

Comme illustré sur la figure 8, deux poignées externes amovibles 13A, 13B sont introduites dans deux orifices 8A diamétralement opposée. Ces poignées sont en forme de simples tirants.

Comme illustré sur les figure 9 et 10, les deux poignées externes amovibles 13A, 13B sont disposées entre deux éléments conducteurs adjacents de l'écran 2A et la bague 8 est glissée sous l'écran de l'extrémité du câble jusqu'à l'endroit de blocage par rotation et coulissement selon la flèche F en suivant le pas de ces deux éléments conducteurs, jusqu'à l'endroit de blocage.

Comme illustré sur la figure 11, les poignées 13A, 13B sont démontées et la seconde bride 9 est alors enfilée sur l'extrémité du câble.

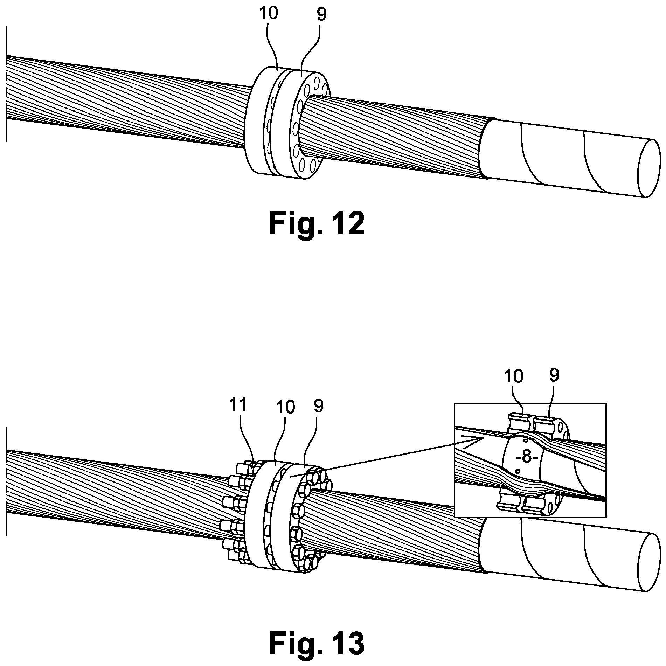

Comme illustré sur la figure 12, les deux brides 9, 10 sont amenées en butée contre le renflement formé par la bague 8 sous l'écran 2A.

Comme illustré sur la figure 13, l'ensemble de vissage 11 constitué d'un certain nombre de boulons est disposé dans des orifices portés par les brides 9, 10 et vient serrer les deux brides contre la bague 8 avec l'écran 2A intercalé.

## Revendications

1. Procédé de gestion de la contraction thermique d'un câble supraconducteur (2) comportant un corps de câble entouré d'un écran externe (2A) constitué de fils ou des bandes résistantes mécaniquement métalliques enroulés selon un certain pas et installé entre ses extrémités dans une enceinte (1) ou cryostat remplie d'un fluide cryogénique, **caractérisé en ce qu'**il consiste à appliquer mécaniquement un effort de blocage radial uniquement dudit écran (2A) en un endroit dit de blocage (5A, 5B) à proximité desdites extrémités du câble, ledit effort de blocage radial ne sollicitant pas ledit corps de câble, le pas desdits fils ou desdites bandes restant constant en dépit d'une force de contraction résultante constante tendant à resserrer ces fils ou bandes enroulés et à diminuer leur pas d'enroulement entre les deux extrémités du câble, une pression radiale sur tous les autres éléments ou couches du câble supraconducteur constituant le corps de câble les bloquant quant à eux et évitant tout déplacement longitudinal dû à la contraction thermique du câble.

2. Procédé selon la revendication précédente, **caractérisé en ce qu'**il consiste à bloquer mécaniquement ledit écran (2A) entre chacune desdites extrémités du câble (2) et ladite enceinte (1).

3. Procédé selon la revendication précédente, **caractérisé en ce qu'**il consiste à bloquer mécaniquement ledit écran (2A) dans un module de cryostat supplémentaire (6A, 6B) intercalé entre chacune desdites extrémités du câble (2) et ladite enceinte (1).

4. Procédé selon l'une des revendications précédentes, **caractérisé en ce que** ledit effort de blocage est transmis à un dispositif de support (7A, 7B) fixé au sol ou équivalent.

5. Procédé selon l'une des revendications précédentes, **caractérisé en ce que** la contraction entre ledit endroit de blocage (5A, 5B) et l'extrémité proche du câble (1) est gérée par un contact glissant.

6. Procédé de gestion de la contraction thermique d'un câble supraconducteur (2) selon l'une des revendications précédentes, au moyen d'un agencement de blocage comportant une bague (8) disposée sous ledit écran (2A) audit endroit de blocage (5A, 5B) et deux brides annulaires (9, 10) de forme interne complémentaire disposées de part et d'autre du plan de symétrie de ladite bague (8) et serrées l'une à l'autre, au moins l'une desdites brides (9, 10) étant solidarisée à un dispositif de support (7A, 7B) fixé au sol ou équivalent,
procédé consistant à glisser ladite bague (8) sous ledit écran (2A) de l'extrémité du câble jusqu'à l'endroit de blocage (5A, 5B) puis à mettre en place lesdites brides (9, 10), ladite bague (8) étant équipée de deux poignées externes amovibles (13A, 13B) disposées entre deux éléments conducteurs adjacents de l'écran (2A) et étant tournée et coulissée jusqu'à l'endroit de blocage (5A, 5B).

## Patentansprüche

1. Verfahren zur Verwaltung der thermischen Kontraktion eines supraleitenden Kabels (2),umfassend einen Kabelkörper, der von einer äußeren Abschirmung (2A) umgeben ist,die aus mechanisch widerstandsfähigen metallischen Drähten besteht,die gemäß einem bestimmten Abstand aufgewickeltund zwischen seinen Enden in einer Hülle (1) oder einem Kryostat installiert sind,gefüllt mit einem kryogenen Fluid,**dadurch gekennzeichnet, dass** es darin besteht,mechanisch eine radiale Blockierkraft nur des Schirms (2A) an einer Stelle, bezeichnet als Blockierstelle (5A, 5B) in der Nähe der Enden des Kabels auszuüben,wobei die radiale Blockierkraft den Kabelkörper nicht vorspannt,wobei die Abstände der Drähte oder der Bänder trotz einer sich ergebenden konstanten Kontraktionskraft gleich bleiben,die dazu neigt, diese gewickelten Drähte oderBänder wieder zu straffenund ihren Aufwicklungsabstand zwischen den zwei Enden des Kabels zu verringern,wobei ein radialer Druck auf alle anderen Elemente oder Schichten des supraleitenden Kabels, die den Kabelkörper darstellen, diese ihrerseits blockiert und jede Längsverschiebung aufgrund der thermischen Kontraktion der Kabel vermeiden.

2. Verfahren nach dem vorhergehenden Anspruch, **dadurch gekennzeichnet, dass** es daraus besteht, die Abschirmung (2A) zwischen jedem der Enden des Kabels (2) und der Hülle (1) mechanisch zu blockieren.

3. Verfahren nach dem vorhergehenden Anspruch, **dadurch gekennzeichnet, dass** es darin besteht, den Schirm (2A) in einem zusätzlichen Kryostatmodul (6A, 6B) mechanisch zu blockieren, das zwischen jedem der Enden des Kabels (2) und der Hülle angeordnet ist.

4. Verfahren nach einem der vorhergehenden Ansprüche, **dadurch gekennzeichnet, dass** die Blockierskraft an eine Stützvorrichtung (7A, 7B) übertragen wird, die auf dem Boden oder Gleichwertigem fixiert wird.

5. Verfahren nach einem der vorhergehenden Ansprüche, **dadurch gekennzeichnet, dass** die Kontraktion zwischen der Blockierstelle (5A, 5B) und dem nahen Ende des Kabels (1)durch einen gleitenden Kontakt verwaltet wird.

6. Verfahren zur Verwaltung der thermischen Kontraktion eines supraleitenden Kabels (2) nach einem der vorhergehenden Ansprüche mit Hilfe einer Blockieranordnung, umfassend einen Ring (8), der unter der Abschirmung (2A) an der Blockierstelle (5A, 5B) angeordnet ist, und zwei ringförmigen Flanschen (9, 10)mit interner komplementärer Form, die auf beiden Seiten der Symmetrieebene des Rings (8) angeordnetund aneinander gestrafft sind, wobei mindestens einer der Flansche (9, 10) mit einer Stützvorrichtung (7A, 7B) fest verbunden ist, die am Boden oder Gleichwertigem fixiert ist,
wobei das Verfahren darin besteht, den Ring (8) unter der Abschirmung (2A) vom Ende des Kabels bis zur Blockierstelle (5A, 5B) zu gleiten, dann die Flansche (9, 10) an ihre Position zu bringen,wobei der Ring (8) mit zwei externen abnehmbaren Griffen (13A, 13B) ausgestattet ist,die zwischen zwei benachbarten leitenden Elementen der Abschirmung (2A) angeordnetund bis zur Blockierstelle (5A, 5B) gedreht und geglitten sind.

## Claims

1. A method for managing the thermal contraction of a superconducting cable (2) including a cable body surrounded by an outer shield (2A) made up of mechanically strong metal wires or strips wound with a certain pitch and installed between its ends in an enclosure (1) or cryostat filled with a cryogenic fluid, **characterized in that** it consists of mechanically applying a radial blocking force only of said shield (2A) in a so-called blocking location (5A, 5B) near said end of the cable, said radial blocking force not stressing said cable body, the pitch of said wires or said strips remaining constant despite a constant resultant contraction force tending to tighten these wound wires or strips and decrease their winding pitch between the two ends of the cable, a radial pressure on all of the other elements or layers of the superconducting cable making up the cable body blocking them and preventing any longitudinal movement due to the thermal contraction of the cable.

2. The method according to the preceding claim, **characterized in that** it consists of mechanically blocking said shield (2A) between each of said ends of the cable (2) and said enclosure (1).

3. The method according to the preceding claim, **characterized in that** it consists of mechanically blocking said shield (2A) in an additional cryostat module (6A, 6B) inserted between each of said ends of the cable (2) and said enclosure (1).

4. The method according to one of the preceding claims, **characterized in that** said blocking force is transmitted to a support device (7A, 7B) fastened to the floor or the like.

5. The method according to one of the preceding claims, **characterized in that** the contraction between said blocking location (5A, 5B) and the closed end of the cable (1) is managed by sliding contact.

6. The method for managing the thermal contraction of a superconducting cable (2) according to one of the preceding claims, using a blocking arrangement including a ring (8) positioned below said shield (2A) at said blocking location (5A, 5B) and two annular flanges (9, 10) with complementary inner shapes positioned on either side of a plane of symmetry of said ring (8) and gripped against one another, at least one of said flanges (9, 10) being secured to a support device (7A, 7B) fastened to the floor or the like,
this method consisting of sliding said ring (8) below said shield (2A) of the end of the cable up to the blocking location (5A, 5B), then placing said flanges (9, 10), said ring (8) being equipped with two removable outer handles (13A, 13B) positioned between two adjacent conducting elements of the shield (2A) and being turned and slid up to the blocking location (5A, 5B).
